**Europäisches Patentamt**

**European Patent Office**

**Office européen des brevets**

(19)

(11) Veröffentlichungsnummer: **0 126 340**
**A2**

(12) # EUROPÄISCHE PATENTANMELDUNG

(21) Anmeldenummer: **84104798.8**

(22) Anmeldetag: **28.04.84**

(51) Int. Cl.³: **H 03 J 5/24**

(30) Priorität: **11.05.83 DE 3317219**

(43) Veröffentlichungstag der Anmeldung: **28.11.84**
**Patentblatt 84/48**

(84) Benannte Vertragsstaaten: **FR GB IT NL SE**

(71) Anmelder: **TELEFUNKEN electronic GmbH,**
**Theresienstrasse 2, D-7100 Heilbronn (DE)**

(72) Erfinder: **Heigl, Franz, Frühlingsstrasse 12,**
**D-8079 Ochsenfeld (DE)**
Erfinder: **Rehm, Josef, Perusastrasse 32,**
**D-8069 Rohrbach (DE)**

(74) Vertreter: **Maute, Hans-Jürgen, Dipl.-Ing., TELEFUNKEN**
**electronic GmbH Theresienstrasse 2, D-7100 Heilbronn**
**(DE)**

(54) **Eingangsschaltung mit wenigstens zwei Eingangswegen.**

(57) Bei einer Eingangsschaltung sind wenigstens zwei Eingangswege 2 bzw. 3 vorgesehen, die wechselweise an einen gemeinsamen Ausgang 6 anschaltbar sind. Die Eingangswege bilden Selektionsglieder für den UHF- bzw. VHF-Frequenzbereich, deren Signale in einem gemeinsamen Vorverstärkerelement verstärkt werden. Um eine gegenseitige Beeinflussung der Selektionsglieder mit einfachen Maßnahmen und Schaltmitteln zu vermeiden, sind Schalter 15 bzw. 20 vorgesehen, die bei UHF-Betrieb leitend sind und dabei den angeschalteten VHF-Eingangsweg kurzschließen.

TELEFUNKEN electronic GmbH
Theresienstr. 2
7100 Heilbronn

Eingangsschaltung mit wenigstens zwei Eingangswegen

Die Erfindung betrifft eine Eingangsschaltung gemäß dem Oberbegriff des ersten Anspruchs.

Bei einer bekannten Eingangsschaltung dieser Art (DE-AS 25 03 785) sind bei einem Kombituner drei getrennte Eingangswege vorgesehen, welche an einem gemeinsamen Eingang liegen und über einzelne, in Serie geschaltete Schalter wechselweise an einen gemeinsamen Ausgang angeschlossen werden können. Die Eingangswege stellen dabei Selektionsglieder für den UHF, VHF-Band III und VHF-Band I-Bereich dar. Der gemeinsame Ausgang ist an eine Steuerelektrode eines gemeinsamen Vorstufentransistors angeschlossen. Bei diesem Aufbau besteht die Gefahr, daß über die Kapazität der Schalter die voll funktionsfähigen Selektionsglieder auf Grund ihrer erwünschten hohen Selektionseigenschaften bei geöffneter Schaltstrecke unzulässig hohe Signale in das Nutzsignal des eingeschalteten Selektionsgliedes einkoppeln.

Der Erfindung liegt die Aufgabe zugrunde, bei einer Eingangsschaltung gemäß dem Oberbegriff des ersten Anspruchs

0126340

Maßnahmen zu treffen, durch welche die volle Wirkung des eingeschalteten Eingangsweges erreicht, der nicht eingeschaltete Eingangsweg jedoch belastet wird.

Die Lösung dieser Aufgabe erfolgt gemäß der Erfindung durch die kennzeichnenden Merkmale des ersten bzw. sechsten Anspruchs.

Bei einer Ausführung gemäß der Erfindung wird der erste Eingangsweg bei durchgeschalteten Schaltern zur vollen Wirkung gebracht, wobei der zweite Eingangsweg am Übergang zum Ausgang mittels des zweiten Schalters kurzgeschlossen wird. Dieser zweite Schalter stellt für den ersten Eingangsweg eine notwendige Masseverbindung her. Bei Anwendung in einem Kombituner für UHF-VHF wird somit das Selektionsglied für UHF zur vollen Wirksamkeit gebracht, während das Selektionsglied für VHF durch den Kurzschluß verstimmt und zusätzlich stark bedämpft wird, so daß keine störenden VHF-Signale über die durchgeschaltete Masseverbindung in das UHF-Selektionsglied eingekoppelt werden. Bei VHF-Betrieb wird dagegen das Selektionsglied für UHF bei geöffneten Schaltern zum einen unterbrochen und zum anderen durch das angeschaltete VHF-Selektionsglied verstimmt, so daß eine Selektion im UHF-Band nicht mehr eintritt.

Bei einer Ausführung gemäß Anspruch 6 mit einem durchstimmbaren UHF-Selektionskreis genügt ein Schalter im Weg von der für den oberen Frequenzbereich notwendigen Abgleichspule nach Masse, weil bei geöffnetem Schalter und durch die dann an den UHF-Selektionskreis angeschalteten Filterelemente für den VHF-Bereich eine so weitgehende Verstimmung eintritt, daß UHF-Signale unterdrückt werden. Die Elemente des UHF-Schwingkreises sind dann gleichzeitig Elemente der VHF-Selektionsglieder.

Vorteilhafte Ausgestaltungen der Erfindung sind in den übrigen Ansprüchen angegeben.

Die Erfindung ist nachfolgend anhand von prinzipiellen Schaltungsbeispielen näher erläutert.

Es zeigen:
        Fig. 1 eine Vorstufenschaltung mit nicht abstimmbaren Selektionsgliedern für den UHF- und
               den VHF-Bereich und
        Fig. 2 eine Vorstufenschaltung mit durchstimmbarem
               UHF-Eingangskreis und nicht durchstimmbaren
               VHF-Selektionsgliedern.

Eine Vorstufe mit einem MOS-Feldeffekttransistor 1 weist ein UHF-Selektionsglied 2 und ein VHF-Selektionsglied 3 auf. Dem VHF-Selektionsglied 3 ist dabei noch ein Tiefpaß 4 vorgeschaltet. Die Eingänge der Selektionsglieder 2, 3 bzw. des Tiefpaßes 4 sind an einen gemeinsamen Antennenanschluß 5 gelegt. Auch der Ausgang der Selektionsglieder ist gemeinsam an ein Gate 6 des MOS-FET 1 geschaltet, dessen zweites Gate 7 für Hochfrequenz praktisch an Masse geschaltet ist. Das verstärkte Hochfrequenzsignal wird dann über die Drainelektrode 8 und einen Trennkondensator 9 an ein nicht dargestelltes Bandfilter weitergeleitet.

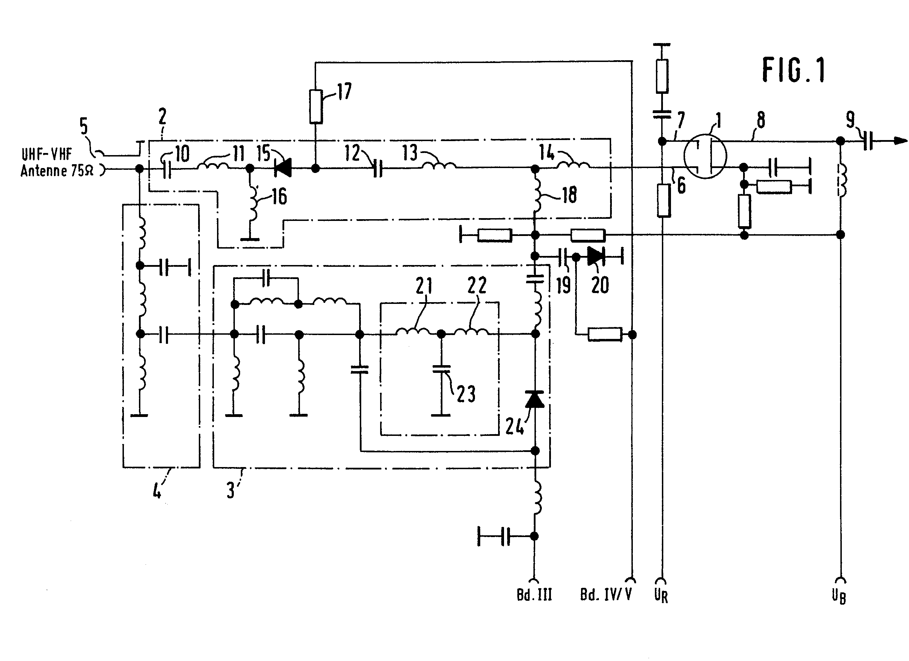

Gemäß Fig. 1 besteht das UHF-Selektionsglied 2 aus einem transformierenden Hochpaß, mit dem eine Anpassung zwischen dem Wellenwiderstand am Antenneneingang 5 und dem Eingangswiderstand am Gate 6 des MOS-FET 1 erreicht wird.

Der Hochpaß besteht dabei aus der Serienschaltung einer Kapazität 10, einer Induktivität 11, einer weiteren Kapazität 12 sowie zwei weiteren Induktivitäten 13 bzw. 14. Zusätzlich ist noch zwischen die Induktivität 11 und die Kapazität 12 eine Schaltdiode 15 gelegt, an deren Verbindungspunkt mit der Induktivität 11 eine Querinduktivität 16 gegen Masse geschaltet ist, während am anderen Anschluß der Schaltdiode 15 die Steuerstromeinspeisung über einen Widerstand 17 erfolgt. Außerdem ist am Verbindungspunkt der Induktivität 13 und der zum Ausgang bzw. dem Gate 6 führenden Induktivität 14 eine zusätzliche Querinduktivität 18 angeschaltet, die über einen Abblockkondensator 19 und eine als weiteren Schalter dienende Schaltdiode 20 an Masse gelegt ist. Der Steuerstrom für die Schaltdiode 20 wird über einen Widerstand eingespeist, der an die gleiche Steuerstromleitung wie der Widerstand 17 gelegt ist. Bei durchgeschalteten Dioden 15, 20 ist somit das UHF-Selektionsglied 2 aktiviert.

Das VHF-Selektionsglied 3 geht am Verbindungspunkt der zweiten Querinduktivität 18 und des Abblockkondensators 19 in das UHF-Selektionsglied 2 über. Bei durchgeschalteter Schaltdiode 20 liegt dieser Verbindungspunkt jedoch hochfrequenzmäßig an Massepotential, so daß die selektierten VHF-Signale gegen Masse geschaltet werden. Sie sind damit bei UHF-Betrieb kurzgeschlossen. Bei gesperrten Dioden 15, 20 ist dagegen das UHF-Selektionsglied 2 gesperrt bzw. verstimmt, während das VHF-Selektionsglied 3 dann über die Querinduktivität 18 und Induktivität 14 das ausgewählte Frequenzband zur Verstärkung auf das Gate 6 des MOS-FET 1 geführt wird.

Im Selektionsglied 3 ist ein Tiefpaßglied aus zwei Längsinduktivitäten 21 und 22 sowie einem Querkondensator 23 eingeschaltet, das über eine dritte Schaltdiode 24 bei Betrieb im VHF-Bereich III über die Schaltdiode 24 kurzgeschlossen ist. Für die Selektierung des VHF-Bereichs I wird dagegen die Schaltdiode 24 gesperrt, so daß das Selektionsglied 3 mit den wirksamen Induktivitäten 21 und 22 sowie dem Querkondensator 23 als Bandpaß arbeitet, der sowohl die Frequenzen des höheren VHF-Bereichs III als auch die tiefer liegende Video-Zwischenfrequenz sperrt.

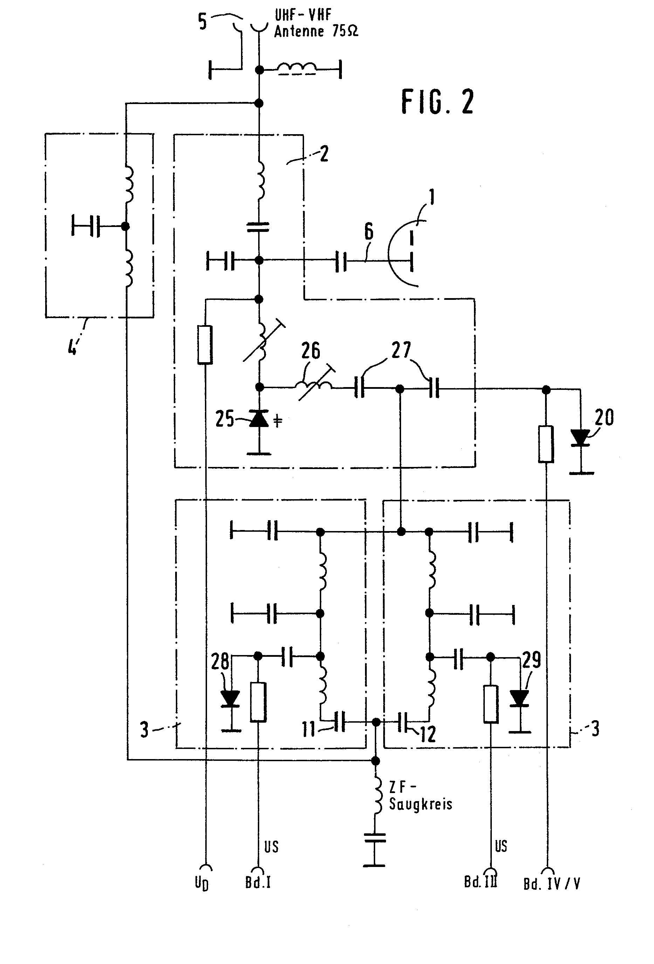

Gemäß Fig. 2 weist die Eingangsschaltung als Selektionsglied für den UHF-Bereich einen durchstimmbaren Stimmkreis in lambda-halbe-Technik mit einer gegen Masse geschalteten Abstimmdiode 25 auf, von der eine Abgleichspule 26 für den oberen Frequenzbereich über Abblockkondensatoren 27 und die als Schalter wirkende Schaltdiode 20 bei UHF-Betrieb an Masse geschaltet ist. Bei UHF-Betrieb wirkt das Selektionsglied 2 somit als lambda-halbe-Schwingkreis, der mittels der Abstimmdiode 25 durchstimmbar ist. Bei VHF-Betrieb dagegen wird die Schaltdiode 20 gesperrt. Dadurch werden die über den Tiefpaß 4 an die Antenne 5 angeschalteten, für den VHF-Bereich I bzw. VHF-Bereich III ausgelegten, gemeinsam an den Verbindungspunkt zwischen den Abblockkondensatoren 27 angeschalteten Selektionsglieder 3 zur Wirkung gebracht. Diese Selektionsglieder 3 sind bei durchgeschalteter Schaltdiode 20 am antennenabgewandten Anschluß wieder gegen Masse kurzgeschlossen. Bei gesperrter Schaltdiode 20 dagegen wird das jeweils selektierte Frequenzband über die Abgleichspule 26 in das Widerstandselement 18 eingespeist und von dort zum Gate 6 des MOS-FET 1 geführt. Über Schaltdioden 28 bzw. 29 kann bei VHF-Betrieb eines der Selektionsglieder hochfrequenzmäßig gegen Masse geschaltet werden, so daß nur die Frequenzen des zweiten Frequenzbereichs selektiert und zum Gate 6 zur weiteren Verstärkung geführt werden.

0126340
6.5.1983
Bt/sta

TELEFUNKEN electronic GmbH
Theresienstr. 2
7100 Heilbronn

## Patentansprüche

1. Eingangsschaltung mit wenigstens zwei Eingangswegen, die wechselweise an einen gemeinsamen Ausgang anschaltbar sind und einen gemeinsamen Masseanschluß aufweisen sowie mit Schaltern für die Eingangswege, insbesondere für Kombituner mit Eingangskreisen für UHF und VHF und einem gemeinsamen Vorverstärkerelement, dadurch gekennzeichnet, daß vom ersten Eingangsweg zwischen dem ersten in Serie liegenden Schalter (15) und dem Ausgang (6) ein Widerstandselement (18) über einen weiteren Schalter (20) an Masse angeschlossen ist, daß an den masseseitigen Anschluß des Widerstandselementes (18) der (die) weitere(n) Eingangsweg(e) (3) angeschlossen ist (sind) und daß beide Schalter (15, 20) jeweils den gleichen Schaltzustand einnehmen.

2. Eingangsschaltung nach Anspruch 1, dadurch gekennzeichnet, daß der erste Eingangsweg (2) ein Hochpaß für den UHF-Bereich mit zwei Querinduktivitäten (16, 18) ist, daß im Längsweg zwischen den Querinduktivitäten (16, 18) der erste Schalter (15) liegt und daß die ausgangsseitige Querinduktivität (18) das Widerstandselement bildet.

0126340
6.5.1983
Bt/sta

3. Eingangsschaltung nach Anspruch 1 oder 2, dadurch gekennzeichnet, daß der erste Schalter (15) eine PIN-Diode ist, die an ihrem ausgangsseitigen Anschluß über einen ohmschen Widerstand (17) an eine Steuerspannungsquelle angeschlossen ist, an der auch eine weitere Diode als zweiter Schalter (20) liegt, und daß der eingangsseitige Anschluß der PIN-Diode (15) an die erste Querinduktivität (16) angeschlossen ist, deren zweiter Anschluß unmittelbar an Masse liegt.

4. Eingangsschaltung nach Anspruch 1 oder einem der folgenden, dadurch gekennzeichnet, daß beide Eingangswege (2, 3) einen gemeinsamen Eingangsanschluß (5) aufweisen, daß in den zweiten Eingangsweg (3) ein Tiefpaß (14) mit einer oberen Grenzfrequenz eingeschaltet ist, die zwischen dem UHF-Bereich und dem VHF-Band III-Bereich liegt und daß in Serie mit dem Tiefpaß (14) ein Hochpaß für den VHF-Band III-Bereich geschaltet ist, dessen untere Grenzfrequenz oberhalt des VHF-Band I-Bereichs liegt.

5. Eingangsschaltung nach Anspruch 4, dadurch gekennzeichnet, daß in den Hochpaß die Serienschaltung aus zwei Induktivitäten (21, 22) gelegt ist, deren Verbindungspunkt über eine Kapazität (23) mit Masse verbunden ist, daß die Serienschaltung (21, 22) mit einer zusätzlichen Schaltdiode (24) überbrückt ist und daß bei gesperrten Schaltdioden (15, 20) der zweite Eingangsweg (3) einen Bandpaß für den VHF-Band I-Bereich bildet.

6. Eingangsschaltung mit wenigstens zwei Eingangswegen, die wechselweise an einen gemeinsamen Ausgang anschaltbar sind und einen gemeinsamen Masseanschluß aufweisen sowie mit Schaltern für die Eingangswege, insbesondere für Kombituner mit Eingangskreisen für UHF und VHF und einem gemeinsamen Vorverstärkerelement, dadurch gekennzeichnet, daß der
erste Eingangsweg (2) nach Art eines lambda-halbe Schwingkreises für den UHF-Bereich mit einer Kapazitätsdiode (25)
im Fußpunkt und einer von der Kapazitätsdiode (25) abgezweigten Abgleichinduktivität (26) für den Abgleich am
oberen Frequenzbandende besteht, die über den ersten Schalter (20) an Masse schaltbar ist und daß zwischen der Abgleichinduktivität (26) und dem Schalter (20) der zweite
Eingangsweg (3) angeschlossen ist.

7. Eingangsschaltung nach Anspruch 6, dadurch gekennzeichnet, daß der Schalter (20) eine Schaltdiode ist, die bei
UHF-Betrieb in den leitenden Schaltzustand geschaltet ist.

8. Eingangsschaltung nach Anspruch 6 oder 7, dadurch gekennzeichnet, daß der zweite Eingangsweg (3) parallel geschaltete Tiefpässe für die VHF-Band I und Band III-Bereiche
aufweist, die über Schaltdioden (28, 29) wechselweise gegen
Masse kurzschließbar sind.

FIG.1

UHF-VHF Antenne 75Ω

Bd.III  Bd.IV/V  $U_R$  $U_B$

1/2

0126340

FIG. 2

0126340